# EUROPEAN PATENT SPECIFICATION

(11) **EP 3 740 968 B1**
(45) Date of publication and mention of the grant of the patent: **03.07.2024**
(21) Application number: 18701694.4
(22) Date of filing: 18.01.2018
(51) Int. Cl.: H01L 23/373

(54) **POWER ELECTRONICS MODULE AND A METHOD OF PRODUCING A POWER ELECTRONICS MODULE**
LEISTUNGSELEKTRONIKMODUL UND VERFAHREN ZUR HERSTELLUNG EINES LEISTUNGSELEKTRONIKMODULS
MODULE ÉLECTRONIQUE DE PUISSANCE ET PROCÉDÉ DE PRODUCTION D'UN MODULE ÉLECTRONIQUE DE PUISSANCE

(43) Date of publication of application: 25.11.2020
(73) Proprietor: ABB Schweiz AG, 5400 Baden (CH)
(72) Inventor: MANNINEN, Jorma, 00380 Helsinki (FI); SILVENNOINEN, Mika, 00380 Helsinki (FI); INGMAN, Kjell, 00380 Helsinki (FI); PAKARINEN, Joni, 00380 Helsinki (FI)
(74) Representative: Kolster Oy Ab
(86) International application number: PCT/EP2018/051179
(87) International publication number: WO 2019/141359

(56) References cited:
- WO-A1-2014/030659
- WO-A1-2017/006661
- DE-A1- 10 157 362
- DE-B3-102015 104 518
- JP-A- 2012 160 642
- US-A1- 2011 070 695
- US-A1- 2013 134 572
- US-B1- 8 575 767
- US-B1- 9 412 679

## Description

### FIELD OF THE INVENTION

The invention relates to power electronics modules, and particularly to a power electronics module with improved cooling properties.

### BACKGROUND OF THE INVENTION

Power electronics modules are commonly used in high powered devices for switching high currents and operating on high voltages. Power electronics modules contain multiple of switch components which are situated in a same component housing and typically internally connected to each other to provide a certain circuit structure.

Power electronics modules are used, for example, for producing certain power conversion circuits, such as inverters and converters. An example of a power electronics module contains two IGBTs (Insulated Gate Bi-polar Transistors) which are connected in series inside the module. Other examples may include bridge topologies or parts of bridge topologies which are readily electrically connected inside the module.

Power electronics modules may also comprise a base plate which is typically made of copper. The purpose of the base plate is to conduct the heat generated by the semiconductors to a cooling device, such as heatsink. The surface of the base plate is typically a substantially planar surface to which a heatsink can be attached. The heatsink is further dimensioned to take into account the amount of heat generated by the semiconductor components in the module.

US9412679 B1 discloses an insulating substrate including a base portion that is made of metal and serves as a radiating surface, an insulating layer, and a circuit pattern. The insulating substrate has convex warpage in the radiating surface at ambient temperature. A power semiconductor element is mounted on the circuit pattern.

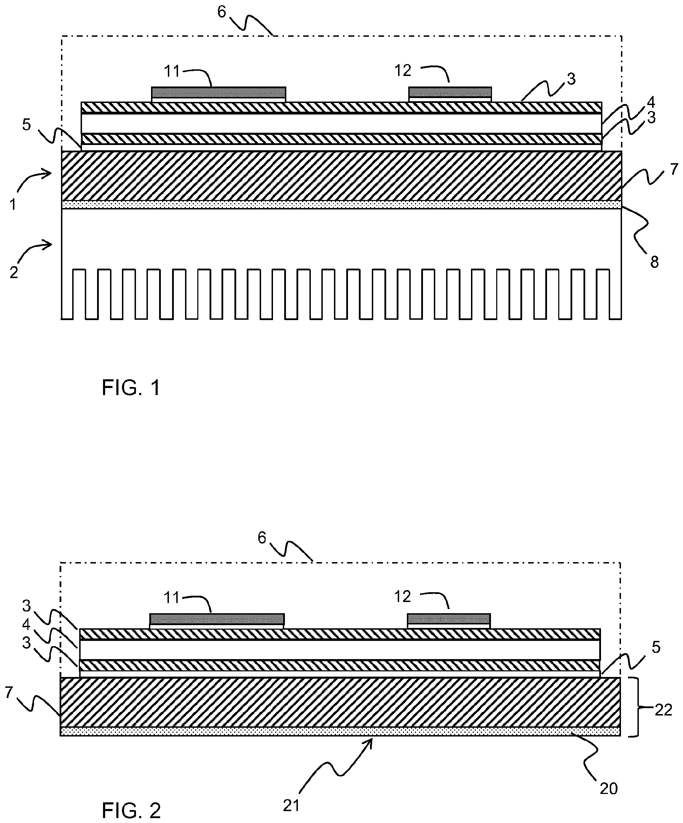

Figure 1 shows an example of a cross-section of a power electronics module 1 attached to a heatsink 2. The power electronics module of the example comprises two semiconductor chips 11, 12 which are soldered to a direct copper bonding (DCB) structure. The DCB structure of the example has two copper plates 3 and a ceramic layer 4 between the copper plates 3. The DCB structure is soldered with a solder layer 5 on the top of a copper base plate 7 of the module. The module further comprises a housing 6 which is shown with a dash-dot line surrounding the DCB structure and the chips.

The module of the example of Figure 1 is attached to an external heatsink such that a thermal interface material 8 layer is placed between the base plate of the module and the base plate of the heatsink. The purpose of the thermal interface material is to transfer the heat from the module's base plate to the heatsink as effectively as possible. It should be noted that Figure 1 is provided only to show an example of structure of power electronic module attached to a heatsink. It is clear that other kinds of structures exist.

Power electronics modules can also be formed without a base plate. In such module, the copper plate of the DCB structure forms the outer surface of the module. For cooling the module, a heatsink or any other cooling device, is attached to the copper plate of the DCB structure.

Power electronic modules' heat loss is dissipated mainly via its base plate that has to be in good thermal connection with a proper cooling device. The latter is clear dimensioning task but managing good and reliable thermal connection between the module and its cooler is more challenging. Thermal connection between two surfaces depends on several properties including their surface roughness (Ra) and surfaces' planarity. In practice the contact of two surfaces is imperfect and there are gaps filled with air in between them. Because air is poor thermal conductor the contact thermal resistance can be reduced by: making the contact surfaces perfectly smooth and planar and/or by replacing the air by a better thermal conducting substance.

Specific materials have been developed to fill air gaps between the surfaces in contact and to reduce contact thermal resistance. These so called thermal interface materials are available in different physical forms like dispensable grease or paste, various thickness rubber like pads, metal foils and so on. These materials are typically mixtures that include carrier or substrate chemical (like silicone oil or rubber) that has been filled with higher thermal conducting material like boron nitride or carbon nanotubes. Typical thermal conductivity of conventional TIMs is relatively low, say 0.7 W/mK ... 5 W/mK, that is often feasible for typical application as the thermal interface materials bond line thickness is only 25 µm to 100 µm. The higher the thermal interface materials thermal conductivity and the thinner it is, lower thermal resistance between power module and the cooling device is obtained. This further results in lower chip temperature level. Some thermal interface materials have also phase changing property, which may be beneficial for example in cyclic operation applications. This type of thermal interface materials are proven to work well in many applications where the contact surface area is relatively small and planar like in CPUs. Lately also graphite/graphene based thermal interface material foils have emerged to the markets and their physical properties differ significantly from conventional TIMs. Graphite sheets act like very soft solid material but they have highly anisotropic thermal conductivity, e.g. in-plane k ~ 1000 W/mK and through-thickness k~6 W/mK.

Power electronics module's internal electronics packing density increases gradually with advanced construction materials and manufacturing methods. This is leading to more challenging module external cooling solutions as devices are able to create very high, over 35 W/cm², hot spots to the heatsink surface.

In view of cooling the situation is most demanding when the module is operated at its maximum current and voltage level i.e. at maximum power. In this condition the conventional aluminium heat sinks' baseplate spreading thermal resistance is too high for the module base plate high heat spots. That is, a conventional aluminium heatsink is not able to spread the heat transferred from the baseplate of the module fast enough. This results in both higher heatsink-to-baseplate temperatures and chip-to-junction temperatures accordingly. Although novel components may allow higher junction temperatures than before due to novel chip material, the component may not be fully utilized unless the power electronics module's external cooling in not at appropriate level.

For the cooling devices to be operational, the power electronics module and the cooling device should be in a thermal contact in which heat is transferred from the power electronics module to the cooling device as efficiently and reliably as possible. That is, the thermal resistance between the module and the heat sink or corresponding cooling device should be as low as possible and should not change during the operation. The use of a thermal interface material layer between the module and the cooling device requires care and attention during the installation of the device as the thermal interface material layers are thin and cumbersome to handle. Further, when heat pastes are used, the amount of paste used should be determined carefully as too thick layer increases the thermal resistance. A further problem with the conventional thermal interface material layers is that the foil-like layers may break and the grease or paste like materials may pump out when the power electronics module twists and bends during use.

### BRIEF DESCRIPTION OF THE INVENTION

An object of the present invention is to provide a power electronics module and a method of producing a power electronics module so as to alleviate the above disadvantages. The objects of the invention are achieved by a method and a device which are characterized by what is stated in the independent claims. The preferred embodiments of the invention are disclosed in the dependent claims.

The invention is based on the idea of applying a soft coating directly to the bottom of the power electronics module, i.e. to a bottom of a heat transfer structure. The coating is applied to a metallic structure which is part of the power electronics module. The metallic structure which forms an outer surface of the module, is either the base plate of the module or copper plate of the DCB (direct bonded copper) structure.

Preferably the material of the soft coating applied to the metallic structure is indium, copper, tin, graphite, polymer or mixture of the materials.

An advantage of the power electronics module of the invention is that the soft coating is readily in place in the module and additional thermal interface layers are not required. The installation of the module to a cooling device is easier than in the prior solutions in which thin films or pastes needs to be handled during the installation.

### BRIEF DESCRIPTION OF THE DRAWINGS

In the following the invention will be described in greater detail by means of preferred embodiments with reference to the attached drawings, in which
Figure 1 shows a known power electronics module with a base plate attached to a heat sink;
Figures 2 shows an embodiment of a power electronics module of the present invention with a base plate;
Figure 3 shows an embodiment of a power electronics module of the present invention without a base plate; and
Figure 4 shows another embodiment of the present invention.

### DETAILED DESCRIPTION OF THE INVENTION

Figure 2 shows a power electronics module of the present invention. In the cross section of Figure 2, the reference numerals correspond to those of Figure 1 for the corresponding parts of the module. The power semiconductor chips 11, 12 are soldered to a DBC structure 3, 4 which is again soldered to a base plate 7.

According to the present invention, a power electronics module comprises multiple of power electronic semiconductor chips 11, 12 incorporated in a housing 6. The module comprises further a heat transfer structure 22 having a surface 21 which forms an outer surface of the module and is adapted to receive a surface of a cooling device, wherein the heat transfer structure 22 comprises a metallic structure 7 having a soft coating 20. In the embodiment of Figure 2, the heat transfer structure 22 consists of the base plate of the power electronics module and of a soft coating 20 applied to the base plate. The surface 21 of the heat transfer structure forms an outer surface or bottom surface of the power electronics module.

The surface 21 of the heat transfer structure is adapted to receive a surface of a cooling device such that the heat from the power electronics module is led to the cooling device. According to the invention, a soft coating is formed directly on the surface of a metallic structure. Thus the power electronics module with a housing comprises a surface that has a soft coating 20.

When a cooling device, such as a heat sink, is attached to the power electronics module of the invention, the soft coating deforms slightly and fills any gaps that may be present in the surface of the cooling device. In known solutions a separate layer is used for producing a good thermal contact between a power electronics module and the heat sink. Such a separate layer has to fill possible air gaps both in the surface of the module and in surface of the cooling device. As the soft coating is applied to the surface of the module, there cannot be any air gaps between the coating and the surface to which is applied.

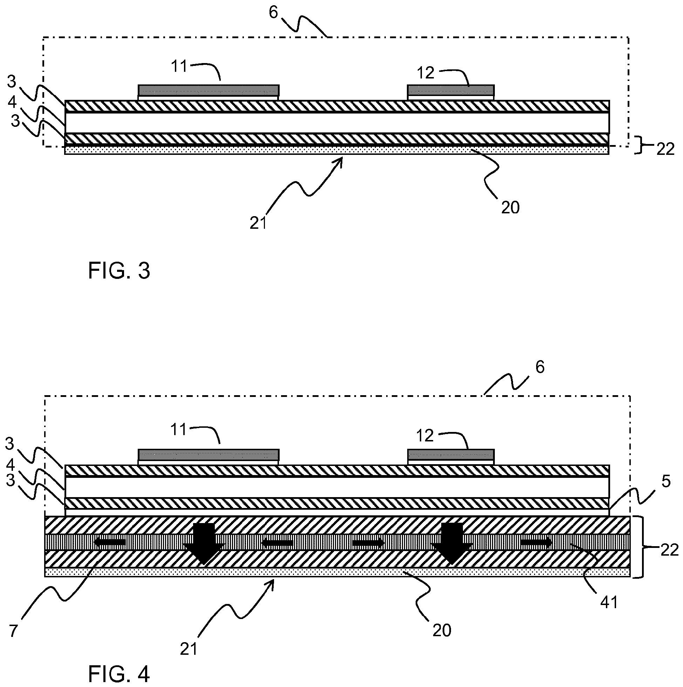

Figure 3 shows another embodiment of the power electronics module of the invention in which the soft coating 20 is applied to a copper layer of the DPC structure. In the embodiment the heat transfer structure is thus formed from the copper layer 3 and the soft coating 20. The module of Figure 3 is a module without a base plate. Thus the bottom surface of the module is formed of the soft coating applied to a metallic structure which is the copper layer 3. The bottom surface is adapted to receive a cooling device for removing and spreading the heat from the module.

According to an embodiment in which the power electronics module comprises a base plate, the base plate comprises a heat spreading graphite structure 41 as shown in Figure 4. The heat spreading graphite structure is preferably formed as a layer or as several layers inside the metallic base plate 7. The purpose of the graphite structure is to spread the heat in a lateral direction of the base plate as indicated by the arrows in Figure 4. Graphite structures may have different heat conduction properties in different directions. When the heat from the power semiconductor chips is led through the base plate, the graphite layer spreads the heat such that the base plate is heated more evenly. When the base plate heats uniformly, the heat transfer from base plate to the cooling device is more efficient than in the case the base plate has warmer and cooler areas. Further, when the thermal mass of the base plate is used efficiently with the aid of the graphite layer, the soft coating of the bottom surface produces efficient cooling properties when a cooling device is attached to the module.

According to an embodiment the material of the soft coating is indium, copper, tin, graphite or polymer. The material of the soft coating may also consist primarily of one of the mentioned materials. When the material consist primarily of the mentioned materials, the material comprises one or more additional materials which may be included to the coating to further enhance the thermal properties or mechanical properties of the coating, for example.

Preferably the coating material is indium based material having a thickness in the range of 25 µm to 350 µm in uncompressed state. The indium based material coating is processed into the power electronics modules baseplate. In case the power semiconductor has no baseplate the indium material layer is processed into the bottom surface of DBC structure.

The natural softness and thickness of the indium allows it to adapt and fill sufficiently (air) gaps between surfaces of power electronics modules base plate and a cooling device during the attachment of the module. Power electronics modules operation and power cycling during the operation causes base plate to bend and/or twist. This means that some new gaps occur in varying locations in between the base plate with Indium coating layer and the cooling surface of the attached external cooling device. However, the indium based material has a relatively high thermal conductivity (k ~ 82 W/mK) compared to conventional thermal interface material layers.

According to the invention, the soft coating is pre-applied into the component DBC substrate's or baseplate's bottom. The coating can be applied by using PVD coating technology and especially with low process temperature DI-ARC^{®} FCAPAD coating method, for example. PVD coating is suitable for very thin coating thicknesses (up to 25 µm) while other known methods may be more suitable for thicker coatings.

When the soft coating is applied to the surface of the power electronics module, it allows easy and fast work in the production of devices employing power electronics modules. When the module of the invention is used, separate thermal interface materials are not needed.

The soft coating has a sufficiently low hardness (approx. Mohs 1.2). The low hardness allows the initial thickness of the coating to reduce and adapt to the cooling surface's surface profile during mounting to its designated value. When a cooling device is properly attached to a power electronics module of the invention, the thickness of the coating is reduced from the above mentioned range of 25 µm to 350 µm.

The soft coating allows further to provide patterns or textures to the metallic surface. That is, the soft coating can be applied in a non-uniform manner if desired. Such a pattern may include dots or lines, for example. Further, the coating may be applied in desired portions of the metallic surface. For example, when the power electronic module is attached with screws or bolts to a cooling device, such as heat sink, it may be desirable that the soft coating is not applied near the holes provided for the screws or bolts. The such areas are left without the soft coating, the pressure between the module and the cooling device may be more desirable in the center areas of the modules base plate.

With the indium based soft coating approximately 16 to 40 times higher thermal conductivity can be achieved when compared to conventionally used thermal interface material layers. Naturally the different alloys of indium can be processed that allows tailoring of physical properties including thermal conductivity and hardness.

According to an embodiment, the indium coating contains small enough (nano/micro) additive substances, diamond or graphite particles to be precise, which enhance the materials thermal conductivity and/or its mechanical properties. The first is beneficial for reducing thermal resistance and the latter for the rigidity of the soft coating against mechanical forces during component operation and thermal cycling. The coating's additive or filler substances physical form may be for example particle, fiber, mesh or net.

In the above, the soft coating is referred specifically to be indium based material. However, tin, copper, polymers and graphite have similar benefits when used as a coating for a bottom surface of the power electronics module. It should be noted, that all the materials can be applied to a metallic surface in a known manner and that the coating is a solid coating in the operating temperatures of the power electronics module.

In the method of producing a power electronics module, the method comprises providing a power electronics module comprising multiple of power electronics semiconductor chips incorporated in housing and having a heat transfer structure having a surface which forms an outer surface of the module, and applying a soft coating to the outer surface of the provided power electronics module. The method of the invention enables to modify an existing power electronics module to module which has better thermal properties.

In the above description embodiments of power electronics module are described quite generally as power electronics modules as such are known in the art. It is, however, clear that such modules have a quite large footprint area and the length of the module is typically in the range of 6 to 25 cm:s. The drawings show cross sections of power electronics modules seen from one end of the module. The modules are shown to be cut in the positions of power electronic semiconductor chips.

It will be obvious to a person skilled in the art that, as the technology advances, the inventive concept can be implemented in various ways. The invention and its embodiments are not limited to the examples described above but may vary within the scope of the claims.

## Claims

1. A power electronics module comprising
multiple of power electronic semiconductor chips incorporated in a housing, and
a heat transfer structure having a surface which forms an outer surface of the module and is adapted to receive a surface of a cooling device, wherein the heat transfer structure comprises a metallic structure having a soft coating,
**characterized in that** the thickness of the soft material layer is in the range of 25 µm to 350 µm, and the soft coating further comprises diamond or graphite particles for enhancing thermal conductivity of the soft coating.

2. A power electronics module according to claim 1, wherein the soft coating forms an outer surface of the module.

3. A power electronics module according to claim 1 or 2, wherein the module comprises a direct bonded copper structure having a top surface and a bottom surface, wherein the power electronic semiconductor chips are attached to the top surface of the direct bonded copper structure and the bottom surface of the direct bonded structure comprises the soft coating.

4. A power electronics module according to clam 1 or 2, wherein the module comprises a base plate and a surface of the base plate comprises the soft coating.

5. A power electronics module according to claim 4, wherein the base plate is a copper base plate.

6. A power electronics module according to claim 4, wherein the base plate is a copper base plate and comprises a layer of graphite inside the copper.

7. A power electronics module according to anyone of the previous claims 1 to 6, wherein the soft coating comprises indium.

8. A power electronics module according to anyone of the previous claims 1 to 7, wherein the material of the soft coating indium-based, graphite-based, copper-based, tin-based or polymer material.

9. A method of producing a power electronics module, the method comprising
providing a power electronics module comprising multiple of power electronics semiconductor chips incorporated in housing and having a heat transfer structure having a surface which forms an outer surface of the module, and
applying a soft coating to the outer surface of the provided power electronics module,
**characterized in that** the thickness of the soft material layer is in the range of 25 µm to 350 µm, and the soft coating further comprises diamond or graphite particles for enhancing thermal conductivity of the soft coating.

10. A method according to claim 9, wherein the material of the soft coating is indium-based, graphite-based, tin-based or polymer material.

11. A method according to claim 9 or 10, wherein the coating is applied using PVD coating technology.

## Patentansprüche

1. Leistungselektronikmodul, umfassend:
eine Vielzahl von Leistungselektronik-Halbleiterchips, die in ein Gehäuse integriert sind, und
eine Wärmeübertragungsstruktur mit einer Oberfläche, die eine Außenfläche des Moduls bildet und zum Aufnehmen einer Oberfläche einer Kühlvorrichtung ausgelegt ist, wobei die Wärmeübertragungsstruktur eine Metallstruktur mit einer weichen Beschichtung umfasst,
**dadurch gekennzeichnet, dass** die Dicke der Schicht aus weichem Material im Bereich von 25 µm bis 350 µm liegt und die weiche Beschichtung ferner Diamant- oder Grafitteilchen zum Verbessern der Wärmeleitfähigkeit der weichen Beschichtung umfasst.

2. Leistungselektronikmodul nach Anspruch 1, wobei die weiche Beschichtung eine Außenfläche des Moduls bildet.

3. Leistungselektronikmodul nach Anspruch 1 oder 2, wobei das Modul eine direkt gebondete Kupferstruktur mit einer oberen Oberfläche und einer unteren Oberfläche umfasst, wobei die Leistungselektronik-Halbleiterchips an der oberen Oberfläche der direkt gebondeten Kupferstruktur angebracht sind und die untere Oberfläche der direkt gebondeten Kupferstruktur die weiche Beschichtung umfasst.

4. Leistungselektronikmodul nach Anspruch 1 oder 2, wobei das Modul eine Basisplatte umfasst und eine Oberfläche der Basisplatte die weiche Beschichtung umfasst.

5. Leistungselektronikmodul nach Anspruch 4, wobei die Basisplatte eine Basisplatte aus Kupfer ist.

6. Leistungselektronikmodul nach Anspruch 4, wobei die Basisplatte eine Basisplatte aus Kupfer ist und eine Schicht aus Grafit innerhalb des Kupfers umfasst.

7. Leistungselektronikmodul nach einem der vorhergehenden Ansprüche 1 bis 6, wobei die weiche Beschichtung Indium umfasst.

8. Leistungselektronikmodul nach einem der vorhergehenden Ansprüche 1 bis 7, wobei das Material der weichen Beschichtung ein Indium-basiertes, Grafitbasiertes, Kupfer-basiertes, Zinn-basiertes oder polymeres Material ist.

9. Verfahren zur Herstellung eines Leistungselektronikmoduls, wobei das Verfahren umfasst:
Bereitstellen eines Leistungselektronikmoduls, das eine Vielzahl von Leistungselektronik-Halbleiterchips umfasst, die in ein Gehäuse integriert sind, und eine Wärmeübertragungsstruktur mit einer Oberfläche aufweist, die eine Außenfläche des Moduls bildet, und
Auftragen einer weichen Beschichtung auf die Außenfläche des bereitgestellten Leistungselektronikmoduls,
**dadurch gekennzeichnet, dass** die Dicke der Schicht aus weichem Material im Bereich von 25 µm bis 350 µm liegt und die weiche Beschichtung ferner Diamant- oder Grafitteilchen zum Verbessern der Wärmeleitfähigkeit der weichen Beschichtung umfasst.

10. Verfahren nach Anspruch 9, wobei das Material der weichen Beschichtung ein Indium-basiertes, Grafitbasiertes, Kupfer-basiertes, Zinn-basiertes oder polymeres Material ist.

11. Verfahren nach Anspruch 9 oder 10, wobei die Beschichtung unter Verwendung einer PVD-Beschichtungstechnologie aufgetragen wird.

## Revendications

1. Module électronique de puissance comprenant
de multiples puces semi-conductrices d'électronique de puissance incorporées dans un boîtier, et
une structure de transfert de chaleur ayant une surface qui forme une surface extérieure du module et qui est adaptée pour recevoir une surface d'un dispositif de refroidissement, la structure de transfert de chaleur comprenant une structure métallique ayant un revêtement souple,
**caractérisé en ce que** l'épaisseur de la couche de matériau souple est comprise entre 25 µm et 350 pm, et **en ce que** le revêtement souple comprend en outre des particules de diamant ou de graphite pour améliorer la conductivité thermique du revêtement souple.

2. Module électronique de puissance selon la revendication 1, le revêtement souple formant une surface extérieure du module.

3. Module électronique de puissance selon la revendication 1 ou 2, le module comprenant une structure de cuivre à liaison directe ayant une surface supérieure et une surface inférieure, les puces semi-conductrices électroniques de puissance étant fixées à la surface supérieure de la structure de cuivre à liaison directe et la surface inférieure de la structure à liaison directe comprenant le revêtement souple.

4. Module électronique de puissance selon la revendication 1 ou 2, le module comprenant une plaque de base et une surface de la plaque de base comprenant le revêtement souple.

5. Module électronique de puissance selon la revendication 4, la plaque de base étant une plaque de base en cuivre.

6. Module électronique de puissance selon la revendication 4, la plaque de base étant une plaque de base en cuivre et comprenant une couche de graphite à l'intérieur du cuivre.

7. Module électronique de puissance selon l'une quelconque des revendications précédentes 1 à 6, le revêtement souple comprenant de l'indium.

8. Module électronique de puissance selon l'une quelconque des revendications précédentes 1 à 7, le matériau du revêtement souple étant à base d'indium, de graphite, de cuivre, d'étain ou de polymère.

9. Procédé de fabrication d'un module électronique de puissance, le procédé comprenant
la fourniture d'un module électronique de puissance comprenant de multiples puces semi-conductrices d'électronique de puissance incorporées dans un boîtier et ayant une structure de transfert de chaleur ayant une surface qui forme une surface extérieure du module, et
l'application d'un revêtement souple sur la surface extérieure du module électronique de puissance fourni,
**caractérisé en ce que** l'épaisseur de la couche de matériau souple est comprise entre 25 µm et 350 pm, et **en ce que** le revêtement souple comprend en outre des particules de diamant ou de graphite pour améliorer la conductivité thermique du revêtement souple.

10. Procédé selon la revendication 9, le matériau du revêtement souple étant à base d'indium, à base de graphite, à base d'étain ou à base de polymère.

11. Procédé selon la revendication 9 ou 10, le revêtement étant appliqué en utilisant la technologie de revêtement PVD.
